Europäisches Patentamt

European Patent Office

Office européen des brevets

(11) Publication number: **0 510 734 A1**

# EUROPEAN PATENT APPLICATION

(21) Application number: 92200372.8

(22) Date of filing: 11.02.92

(51) Int. Cl.5: **H01L 23/467**, H01L 23/373, H01L 23/473

(30) Priority: 20.02.91 NL 9100296

(43) Date of publication of application:
28.10.92 Bulletin 92/44

(84) Designated Contracting States:
AT BE CH DE ES FR GB IT LI LU NL SE

(71) Applicant: AKZO N.V.
Velperweg 76
NL-6824 BM Arnhem(NL)

(72) Inventor: Willemsen, Henricus Petrus
Lieshoutseweg 72
NL-5735 RD Aarle-Rixtel(NL)

Inventor: Dirix, Carolina Anna Maria Christina
De Ham 13
NL-6932 BR Westervoort(NL)
Inventor: Te Boekhorst, Theodorus Gerhardus
Johannes
Adenauerstraat 17
NL-6904 ND Zevenaar(NL)

(74) Representative: Schalkwijk, Pieter Cornelis et
al
AKZO N.V., Patent Department (Dept. APTA),
P.O. Box 9300
NL-6800 SB Arnhem(NL)

(54) **Heat exchanging member, more particularly for cooling a semiconductor module.**

(57) A heat exchanging member (1), more particularly for cooling a semiconductor module, having at a first and a second side, respectively, inlets and outlets, respectively, for a preferably gaseous heat exchanging medium, and having a heat exchanging component (2) made of a highly thermal conductive material, such as metal, in which channels disposed side by side and running from its inlet side to its outlet side have been formed, such that medium flowing in through the inlet channels is constrained to flow at an angle to the direction of entry via the heat exchanging material to the adjacent outlet channels, characterized in that the heat exchanging material has a structure which
 a) is composed of randomly packed elementary parts, such as grains, fibres or scales, or
 b) is composed of parts packed in an ordered fashion, such as gauze or plates, with the exception of individual wires.
 In a preferred embodiment the heat exchanging material is made up of sintering bronze.

FIG. 1.

EP 0 510 734 A1

The invention relates to a heat exchanging member, more particularly for cooling a semiconductor module, having at a first and a second side, respectively, inlets and outlets, respectively, for a gaseous or a liquid heat exchanging medium, and having a heat exchanging component made of a highly thermal conductive material, such as metal, in which channels disposed side by side and running from its inlet side to its outlet side have been formed, such that medium flowing in through the inlet channels is constrained to flow at an angle to the direction of entry via the heat exchanging material to the adjacent outlet channels.

Such a heat exchanging member is in itself known from EP-A O 376 365. In this known member the heat exchanging component is built up of rows of thin wire members, which rows are of triangular cross-section. This gives an especially large heat dissipating surface area, resulting in a particularly high performance, also because of the special way in which the gaseous heat exchanging medium is constrained to flow. However, this known construction is comparatively difficult to make and less suited to mass manufacturing.

The invention envisages providing a heat exchanging member as described above, which is free of these drawbacks and yet has a performance which almost matches that of the known heat exchanging member.

CA 1 238 428 describes a different type of heat sink for a semiconductor module, one which contains thin cooling fins in the form of protrusions composed of multiple fused thermal conductive spheroids.

EP O 174 537 A1 describes another type of cooling member for a semiconductor module, one which may be composed of copper fibres having an elastic felt structure.

Described in EP 0 237 741 A3 is yet another type of device for cooling electronic components, one in which a porous layer composed of sintered ultrafine grains and having microscopic liquid-filled cavities is provided between a heat generating element and a heat sink element.

US 4 884 631 describes another heat sink apparatus for semiconductors still, in which there is forced flow of cooling air through various structure material configurations, such as honeycomb, corrugated, or serpentine.

Reference is also made to US 4 843 693 and to "Serpentine Copper Mesh Forms Heat Sinks," Electronic Packaging and Production (Newton, Massachusetts, USA), Vol. 30., No. 10 (October 1990), p. 47. The use of corrugated copper mesh in a heat exchanger for electronic components is in itself known from these publications.

US 4 531 145 describes another type of apparatus, one with a substrate of sintered aluminium oxide to which chips are attached and with channels for a coolant provided therein.

From EP 0 413 498 A2's description of a different type of cooling element for electronic components the use of flat wire mesh packages for heat exchanging is in itself known.

In EP 194 358 B1 still another type of heat sink for electronic components is described, use being made of a body of specially sintered boron nitride with cooling fins.

According to the invention this object is attained because the heat exchanging material has a structure which

    a) is composed of randomly packed elementary parts, such as grains, fibres or scales, or

    b) is composed of parts packed in an ordered fashion, such as gauze or plates, except for individual wires.

Such a structure is easily manufactured in any desired configuration and has a very large heat exchanging surface area at a comparatively low flow resistance.

According to the invention the construction advantageously is such that at least 50 wt.%, preferably 50-100 wt.% of the grains or the fibres has a diameter of at most 10 $\mu$m to 2000 $\mu$m, at least 50 wt.%, preferably 50-100 wt.% of the, preferably slightly curved, scales and the plates has a thickness of at most 10 $\mu$m to 2000 $\mu$m, and at least 50 wt.%, preferably 50-100 wt.% of the, preferably copper, gauze has a mesh size of at most 10 $\mu$m to 2000 $\mu$m.

The heat exchanging member according to the invention is further characterized in that at least 50 wt.%, preferably 50-100 wt.% of the randomly packed elementary parts or the parts packed in an ordered fashion have a characteristic diameter of at most 10 $\mu$m to 2000 $\mu$m. A preferred embodiment of the heat exchanging member according to the invention is characterized in that the randomly packed elementary parts or the parts packed in an ordered fashion have a characteristic diameter of at most 10 $\mu$m to 2000 $\mu$m, preferably 50 $\mu$m to 1000 $\mu$m. Especially favourable results can be obtained when the heat exchanging member according to the invention is characterized in that the randomly packed elementary parts or the parts packed in an ordered fashion have a characteristic diameter of virtually equal magnitude. In other words, when said parts are in the form of grains, these grains will, according to the invention, preferably be of about the same magnitude.

By said characteristic diameter of said randomly packed elementary parts or said parts packed in an ordered fashion is meant the diameter in the case of by and large three-dimensional and one-dimensional parts, such as grains or fibres, the thickness in the case of by and large two-dimensional parts, such as scales, or the mesh size in the case of gauze.

Preferably in such a case the heat exchanging component is made of sintering metal, more particularly of sintering bronze.

In a preferred embodiment the heat exchanging component and the channels present in it have been made as one, with the bottom of the inlet and outlet channels being positioned at some distance from the component's under-face.

In a favourable preferred embodiment the inlet and outlet channels have been constructed as straight, mutually parallel channels in the heat exchanging component, which is closed at its upper- and under-faces, and on the upper-face of which have been disposed, inclined at an acute angle to each other and covered by a covering plate, elongated medium-guiding plates, each running from the end of an outlet channel on the inlet side to the end of an adjacent inlet channel on the outlet side.

The distance between the medium-guiding plates at the inlet side preferably equals this distance at the outlet side and is in the range of 0,5-20 mm, preferably in the range of 2-10 mm, and the width of each channel preferably equals 0,1-0,5 times the width of such a channel augmented by the width of a strip of heat exchanging material as defined by two adjacent channels.

In an especially favourable process for the manufacture of the heat exchanging member according to the invention granular material is compressed and sintered to form a structure consisting of ribs separated by grooves, whereupon the ribs are shortened by being cut at some distance from their tops to obtain a heat exchanging component. So, according to this process the heat exchanging material is manufactured in greater lengths, and sections of this semimanufactured product are removed and then combined with an extension piece also pre-manufactured as a semiproduct by plastics moulding and comprising the guiding plates and a covering plate. In this manner particularly simple and inexpensive manufacture is made possible, thus permitting simple and rapid adjustment to the configuration of a specific semiconductor module.

The invention will be illustrated with reference to the drawing. In it:

Fig. 1 is a perspective view, partially cut away, of part of a heat exchanging member according to the invention.

Fig. 2 is a front view of this embodiment.

Fig. 3 is a schematic top view of such an embodiment.

Fig. 4a is a schematic perspective view, partially cut away, of a construction in which the heat exchanging material is a sintering metal.

Fig. 4b is a front view of this embodiment.

Figs. 5a and 5b are similar views of an embodiment in which the heat exchanging material is of metal fibres.

Fig. 6 is a view corresponding to Fig. 5a of an embodiment in which use is also made of a gauze-like material.

Figs. 7a and 7b are views corresponding to Figs. 4a and 4b of an embodiment in which the heat exchanging material has a fin-shaped configuration made up of plates.

Fig. 8 is a front view of part of a semimanufactured product from which the heat exchanging components according to the invention can be made.

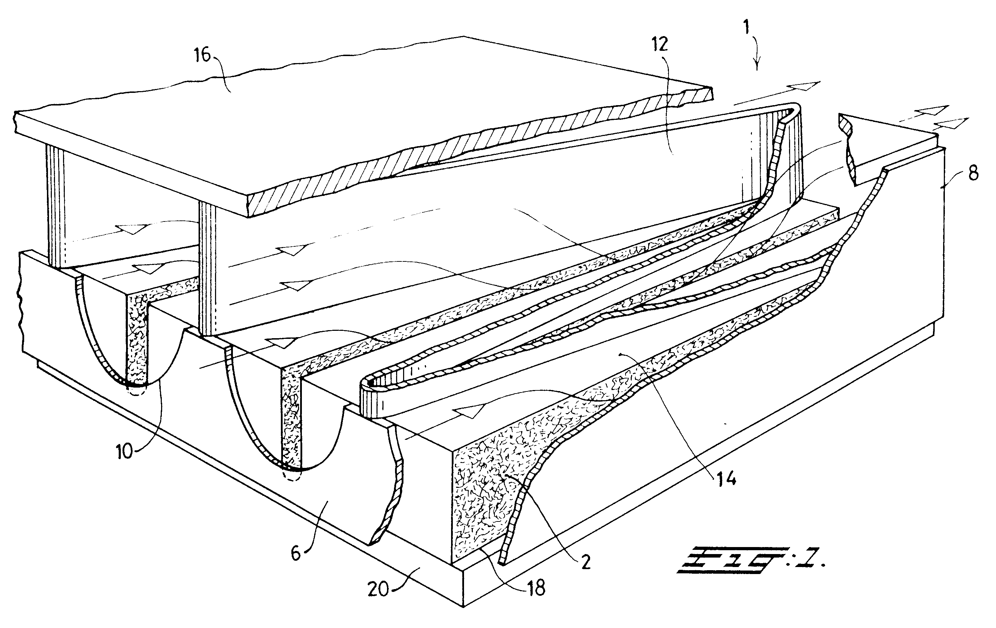

The heat exchanging member 1 depicted in Figs. 1-3 comprises a heat exchanging component 2, which has a structure composed of packed discrete granular particles; their largest dimension is in the range of 100 $\mu$m to 1000 $\mu$m.

In between these particles there are interspaces through which a gaseous medium, more particularly air can flow.

A highly suitable material for use in this heat exchanging component is sintering bronze.

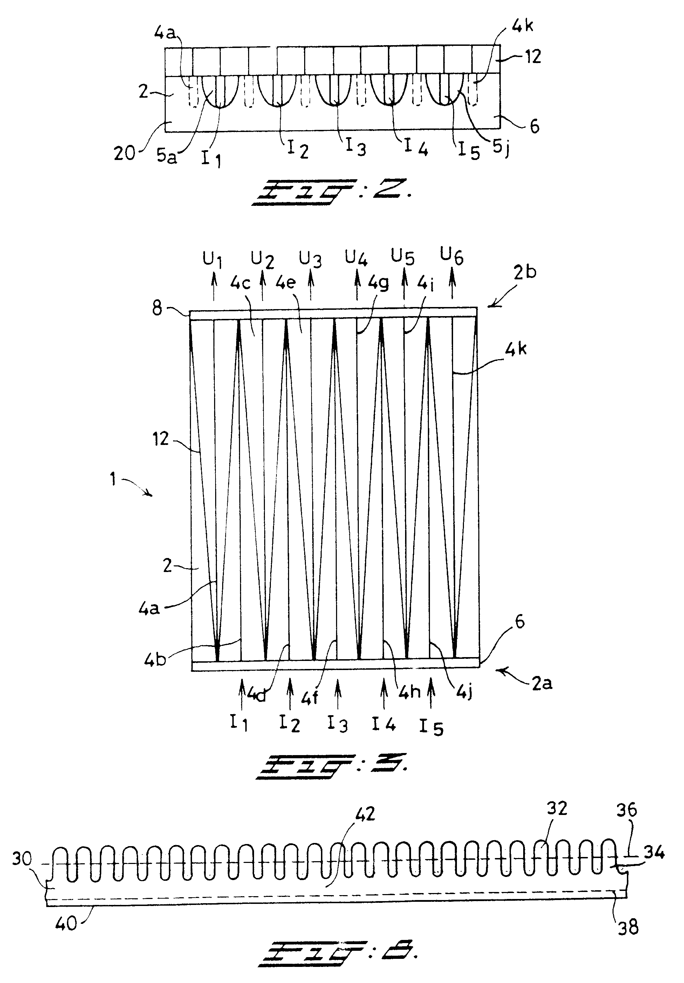

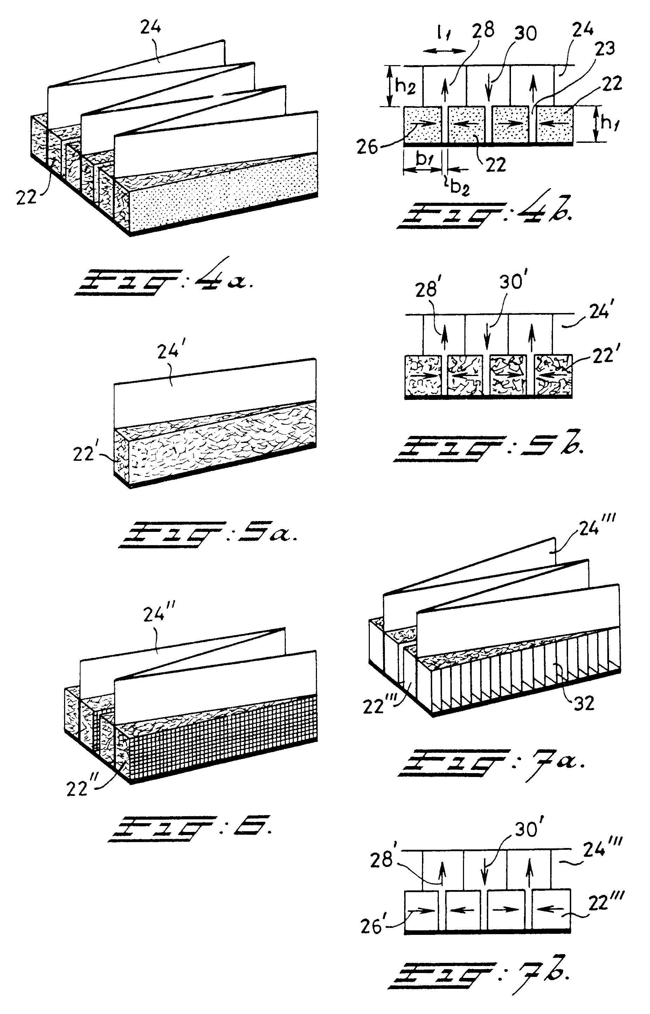

In the heat exchanging component there are a number of mutually parallel grooves 4, which are indicated in Fig. 3 with 4a..4k. The heat exchanging component 2 has an inlet side 2a where the heat exchanging medium is fed and an outlet side 2b where it is discharged; the grooves 4b, 4d, 4f, 4h, and 4j form the inlet channels i1..i5, while the grooves 4a, 4c, 4e, 4g, 4i, and 4k form the outlet channels u1..u6. So, between the grooves 4a..4k there are strips of heat exchanging material 5a..5j through which the heat exchanging medium flows. The inlet channels i1..i5 each are closed at the outlet end 2b and the outlet channels u1..u6 are closed at the inlet end 2a. For this purpose a plate 6 provided with appropriate recesses has been provided at the inlet end 2a and a similar plate 8 at the outlet end 2b.

Guiding plates 12, each running from the end of an outlet channel situated at the inlet side 2a to the end of an inlet channel situated at the outlet side 2b, provide extra guiding to the cooling medium, which, due to the fact that the heat exchanging component 2 is closed at the upper face 14, can only flow through the heat exchanging material along the vertical walls of the grooves. A covering plate 16 completes the heat exchanging member, of which the bottom 18 is mounted in an appropriate manner on a base 20, which is in thermal conductive contact with the strips 5a..5j; such a base may for instance take the form of a semiconductor module which has to be cooled. In the resulting member the heat exchanging medium fed via the inlet recesses 10 in the plate 6 will be constrained to flow via the inlet grooves and through the strips of heat exchanging material 5a..5j to the outlet grooves forming the outlet channels, such as is indicated in Fig. 4b.

Figs. 4a, 4b; 5a, 5b; 6, and 7a, 7b are views of different embodiments. In the embodiment according to Figs. 4a, 4b the strips of heat exchanging material, indicated with 22, consist of sintered grains, fibres, or irregularly shaped particles. The direction of flow of the medium through the heat exchanging material 22 and the guiding plates 24 is indicated with the arrows 26, 28, and 30. The same numerals with single prime are used to indicate corresponding parts in the Figs. 5a and 5b relating to an embodiment in which the strips of heat exchanging material 22' are composed of metal fibres or randomly packed gauze. Fig. 6 relates to an embodiment in which the strips of heat exchanging material 22'' are composed of stacked layers of gauze.

Finally, Figs. 7a, 7b relate to an embodiment in which the strips of heat exchanging material 22''' are composed of fins 32 arranged adjacently.

Preferably, the characteristic dimension or diameter of the elementary material of which the heat exchanging structure used is built up is 100-1000 $\mu$m, and for the different dimensions indicated only in Fig. 4b the following values may be used:

Distance 11 between the guiding plates 24 at the inlet and outlet sides, respectively (which may also be referred to as the "zigzag pitch"): in the range of 0,5 to 20 mm, preferably in the range of 2 to 10 mm. This distance is equal to the width b1 of a strip 22 plus the width b2 of a groove 23 separating the strips; said width b2 preferably is in the range of 0,1 to 0,5 times the value (b1 + b2).

The high cooling performance to be obtained is illustrated by the fact that, using a heat exchanging member with a configuration as depicted in Figs. 1-4b and having the following parameters:

| | |
|---|---|
| length x width | = 100 x 100 mm |
| number of sintering components (5a..4j, or 22) | = 25 |
| width (b1) of sintering component | = 3 mm |
| height (h1) of sintering component | = 4 mm |
| width (b2) of grooves (4a..4h or 23) | = 1 mm |
| height of guiding plates (h2) | = 6 mm |
| air throughput | = 10 l/sec |
| temperature difference between incoming air and base plate | = 50°K |
| average grain diameter | = 500 $\mu$m |
| it is possible to dissipate 500W of power. | |

The invention further proposes a particularly simple process for the manufacturing such a heat exchanging means. To this end, bronze grains are sintered to form a semimanufactured product 30 having a cross-section as indicated in Fig. 8. By sawing off the top end sections 32 of the formed ribs 34 along the line 36 the configuration according to Fig. 2 is obtained, the advantage of this process being that the top area of the ribs has already been "stopped" and so requires no further sealing. A corresponding process is carried out along the line 38 at a short distance from the under-face 40 of the semimanufactured product 30, so that also here a sealed bottom area is obtained. Next, the semimanufactured product is split up along the transverse lines 42 to give the desired width and shortened to the desired length, after which the heat exchanging component obtained in the Figs. 2 and 3 has been actualized.

Within the framework of the invention various changes can be made. In addition to cooling semiconductor modules the heat exchanger according to the invention can advantageously be employed in the cooling of rotary or linear high performance engines, lasers, power supplies (power bricks), power electronics, an output amplifier in a high-powered amplifier. In addition to being of sintering bronze the heat exchanging component may advantageously be of other highly thermal conducting metals or metal alloys, such as aluminium or aluminium alloys. Instead of employing grains of metal for the heat exchanging component it is also possible to make use of diamond grais or metallised grains of organic material. According to the invention use may with advantage be made of a liquid cooling medium, more particularly water, as well as a gaseous one.

By the diameter of the grains composed of, say, sintering metal is meant the largest transverse dimension of said grains.

**Claims**

1. A heat exchanging member, more particularly for cooling a semiconductor module, having at a first and a second side, respectively, inlets and outlets, respectively, for a preferably gaseous heat exchanging medium, and having a heat exchanging component made of a highly thermal conductive material, such as metal, in which channels disposed side by side and running from its inlet side to its outlet side have been formed, such that medium flowing in through the inlet channels is constrained to flow at an angle to the direction of entry via the heat exchanging material to the adjacent outlet channels, characterized in that the heat exchanging material has a structure which
   a) is composed of randomly packed elementary parts, such as grains, fibres or scales, or
   b) is composed of parts packed in an ordered fashion, such as gauze or plates, with the exception of individual wires.

2. A heat exchanging member according to claim 1, characterized in that at least 50 wt.% of the grains or the fibres has a diameter of at most 10 $\mu$m to 2000 $\mu$m, at least 50 wt.% of the, preferably slightly curved, scales and the plates has a thickness of at most 10 $\mu$m to 2000 $\mu$m, and at least 50 wt.% of the, preferably copper, gauze has a mesh size of at most 10 $\mu$m to 2000 $\mu$m.

3. A heat exchanging member according to claim 2, characterized in that 50-100 wt.% of the grains or the fibres has a diameter of at most 10 $\mu$m to 2000 $\mu$m, 50-100 wt.% of the, preferably slightly curved, scales and the plates has a thickness of at most 10 $\mu$m to 2000 $\mu$m, and 50-100 wt.% of the, preferably copper, gauze has a mesh size of at most 10 $\mu$m to 2000 $\mu$m.

4. A heat exchanging member according to claim 1, characterized in that at least 50 wt.% of the randomly packed elementary parts or the parts packed in an ordered fashion have a characteristic diameter of at most 10 $\mu$m to 2000 $\mu$m.

5. A heat exchanging member according to claim 4, characterized in that 50-100 wt.% of the randomly packed elementary parts or the parts packed in an ordered fashion have a characteristic diameter of at most 10 $\mu$m to 2000 $\mu$m.

6. A heat exchanging member according to claim 1, characterized in that the randomly packed elementary parts or the parts packed in an ordered fashion have a characteristic diameter of at most 10 $\mu$m to 2000 $\mu$m, preferably 50 $\mu$m to 1000 $\mu$m.

7. A heat exchanging member according to claim 1, characterized in that the randomly packed elementary parts or the parts packed in an ordered fashion have a characteristic diameter of virtually equal magnitude.

8. A heat exchanging member according to claim 1, characterized in that the heat exchanging component is made of sintering metal, such as sintering bronze.

9. A heat exchanging member according to claim 8, characterized in that the heat exchanging component and the channels present in it have been made as one, with the bottom of the inlet and outlet channels being positioned at some distance from the component's under-face.

10. A heat exchanging member according to claim 1, characterized in that the inlet and outlet channels have been constructed as straight, mutually parallel channels in the heat exchanging component, which is closed at its upper- and under-faces, and on the upper-face of which have been disposed, inclined at an acute angle to each other and covered by a covering plate, elongated medium-guiding plates, each running from the end of an outlet channel on the inlet side to the end of an adjacent inlet channel on the outlet side.

11. A heat exchanging medium according to claim 10, characterized in that the distance between the medium-guiding plates at the inlet side equals this distance at the outlet side and is in the range of 0,5-20 mm, preferably in the range of 2-10 mm.

**12.** A heat exchanging member according to claim 10, characterized in that the width of each channel equals 0,1-0,5 times the width of such a channel augmented by the width of a strip of heat exchanging material as defined by two adjacent channels.

**13.** A process for the manufacture of a heat exchanging member according to claim 8, characterized in that granular material is compressed and sintered to form a structure consisting of ribs separated by grooves, whereupon the ribs are shortened by being cut at some distance from their tops to obtain a heat exchanging component.

**14.** A process according to claim 13, characterized in that the resulting heat exchanging component is combined with a unit obtained by plastics moulding and comprising the medium-guiding plates and a covering plate.

FIG. 1.

**Fig. 2.**

**Fig. 3.**

**Fig. 8.**

FIG: 4a.

FIG: 4b.

FIG: 5a.

FIG: 5b.

FIG: 6.

FIG: 7a.

FIG: 7b.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,Y | EP-A-0 376 365 (AKZO N.V.) 4 July 1990<br>* claims 1,13,19 * | 1<br><br>10 | H01L23/467<br>H01L23/373<br>H01L23/473 |
| Y | CA-A-1 261 482 (J.J. KOST) 26 September 1989<br>* claim 1 * | 1 | |
| A | | 8,9,13 | |
| D,A | EP-A-0 174 537 (SIEMENS) 19 March 1986<br>* page 7, line 16 - line 23; figure 1 * | 1 | |
| D,A | ELECTRONIC PACKAGING & PRODUCTION<br>vol. 30, no. 10, October 1990, NEWTON, US<br>page 47; 'SERPENTINE COPPER MESH FORMS HEAT SINKS' | 1,2 | |
| D,A | EP-A-0 237 741 (HITACHI LTD) 23 September 1987<br>* claims 1,2 * | 1,2,13 | |
| A | EP-A-0 009 605 (IBM) 16 April 1980 | | |
| A | PATENT ABSTRACTS OF JAPAN<br>vol. 6, no. 254 (E-148)(1132) 14 December 1982<br>& JP-A-57 153 458 ( NIPPON DIA CLEVITE K.K. ) 22 September 1982<br>* abstract * | | TECHNICAL FIELDS SEARCHED (Int. Cl.5)<br><br>H01L |

The present search report has been drawn up for all claims

| Place of search | Date of completion of the search | Examiner |
|---|---|---|
| THE HAGUE | 21 APRIL 1992 | DE RAEVE R.A.L. |

EPO FORM 1503 03.82 (P0401)